# EUROPEAN PATENT APPLICATION

(11) **EP 2 500 396 A2**
(43) Date of publication of application: **19.09.2012**
(21) Application number: 12172070.0
(22) Date of filing: 28.07.2008
(51) Int. Cl.: C09K 11/02, C09K 11/70, C30B 7/14

(54) **Nanoparticles**

(30) Priority: 31.07.2007 GB 0714865
(62) Divisional of application: 08776067.4
(71) Applicant: Nanoco Technologies Limited, Manchester M13 9NT (GB)
(72) Inventor: The designation of the inventor has not yet been filed
(74) Representative: Dauncey, Mark Peter

(57) **Abstract**

A nanoparticle comprised of a molecular cluster compound incorporating ions from groups 12 and 16 of the periodic table, and a core semiconductor material provided on said molecular cluster compound, wherein the core semiconductor material incorporates ions from groups 13 and 15 of the periodic table.

## Description

The present invention relates to semiconductor nanoparticles.

There has been substantial interest in the preparation and characterisation of compound semiconductors consisting of particles with dimensions, for example in the range 2-50 nm, often referred to as 'quantum dots' or nanocrystals. These studies have occurred mainly due to the size-tuneable electronic properties of these materials that can be exploited in many commercial applications such as optical and electronic devices and other applications that now range from biological labelling, solar cells, catalysis, biological imaging, light-emitting diodes, general space lighting and both electroluminescence and photoluminescence displays amongst many new and emerging applications.

The most studied of semiconductor materials have been the chalcogenide II-VI (i.e. group 12 - group 16) materials, such as ZnS, ZnSe, CdS, CdSe and CdTe. Most noticeably, CdSe has been greatly studied due to its optical tuneability over the visible region of the spectrum. Although some earlier examples appear in the literature, more recently, reproducible methods have been developed from "bottom up" techniques, whereby particles are prepared atom-by-atom using "wet" chemical procedures.

Two fundamental factors, both related to the size of the individual semiconductor nanoparticle, are responsible for the unique properties of these particles. The first is the large surface-to-volume ratio: as a particle becomes smaller, the ratio of the number of surface atoms to those in the interior increases. This leads to the surface properties playing an important role in the overall properties of the material. The second factor is that, with semiconductor nanoparticles, there is a change in the electronic properties of the material with size, moreover, the band gap gradually becoming larger because of quantum confinement effects as the size of the particles decreases. This effect is a consequence of the confinement of an 'electron in a box' giving rise to discrete energy levels similar to those observed in atoms and molecules, rather than a continuous band as in the corresponding bulk semiconductor material. Thus, for a semiconductor nanoparticle, because of the physical parameters, the "electron and hole", produced by the absorption of electromagnetic radiation (a photon) with energy greater then the first excitonic transition, are closer together than in the corresponding macrocrystalline material, so that the Coulombic interaction cannot be neglected. This leads to a narrow bandwidth emission, which is dependent upon the particle size and composition. Thus, quantum dots have higher kinetic energy than the corresponding macrocrystalline material and consequently the first excitonic transition (band gap) increases in energy with decreasing particle diameter.

Single core semiconductor nanoparticles, which consist of a single semiconductor material along with an outer organic passivating layer, can have relatively low quantum efficiencies due to electron-hole recombination occurring at defects and dangling bonds situated on the nanoparticle surface which lead to non-radiative electron-hole recombinations.

One method to eliminate defects and dangling bonds is to grow a second inorganic material, having a wider band-gap and small lattice mismatch to that of the core material epitaxially on the surface of the core particle, to produce a "core-shell" particle. Core-shell particles separate any carriers confined in the core from surface states that would otherwise act as non-radiative recombination centres. One example is ZnS grown on the surface of a CdSe core to provide a CdSe/ZnS core/shell nanoparticle.

Another approach is to prepare a core/multi-shell structure where the "electron-hole" pair is completely confined to a single shell layer such as the quantum dot-quantum well structure. Here, the core is of a wide bandgap material, followed by a thin shell of narrower bandgap material, and capped with a further wide bandgap layer, such as CdS/HgS/CdS grown using a substitution of Hg for Cd on the surface of the core nanocrystal to deposit just a few monolayers of HgS. The resulting structures exhibited clear confinement of photo-excited carriers in the HgS layer.

The coordination about the final inorganic surface atoms in any core, core-shell or core-multi shell nanoparticle is incomplete, with highly reactive non-fully coordinated atoms "dangling bonds" on the surface of the particle, which can lead to particle agglomeration. This problem is overcome by passivating (capping) the "bare" surface atoms with protecting organic groups.

The outer most layer (capping agent) of organic material or sheath material helps to inhibit particle aggregation and also further protects the nanoparticle from their surrounding chemical environment and it also provide a means of chemical linkage to other inorganic, organic or biological material. In many cases, the capping agent is the solvent that the nanoparticle preparation is undertaken in, and consists of a Lewis base compound, or a Lewis base compound diluted in an inert solvent, such as a hydrocarbon, whereby there is a lone pair of electrons that are capable of donor type coordination to the surface of the nanoparticle.

Important issues concerning the synthesis of high quality semiconductor nanoparticles are particle uniformity, size distribution, quantum efficiencies and use in commercial applications their long-term chemical and photostability. Early routes applied conventional colloidal aqueous chemistry, with more recent methods involving the kinetically controlled precipitation of nanocrystallites, using organometallic compounds. Most of the more recent methods are based on the original "nucleation and growth" method described by Murray, Norris and Bawendi¹, but use other precursors from that of the organometallic ones originally used, such as oxides (e.g. CdO), carbonates (e.g. MCO₃), acetates (e.g. M(CH₃CO₂)) and acetylacetanates (e.g. M[CH₃COOCH=C(C-)CH₃]₂) in which, for example, M = Cd or Zn.

Murray *et al*¹ originally used organometallic solutions of metal-alkyls (R₂M) where M = Cd, Zn, Te; R = Me, Et and tri-*n*-octylphosphine sulfide/selenide (TOPS/Se) dissolved in tri-*n*-octylphosphine (TOP). These precursor solutions are injected into hot tri-*n*-octylphosphine oxide (TOPO) in the temperature range 120-400°C depending on the material being produced. This produces TOPO coated/capped semiconductor nanoparticles of II-VI material. The size of the particles is controlled by the temperature, capping agent, concentration of precursor used and the length of time at which the synthesis is undertaken, with larger particles being obtained at higher temperatures, higher precursor concentrations and prolonged reaction times. This organometallic route has advantages over other synthetic methods, including greater monodispersity and high particle cystallinity. As mentioned, many variations of this method have now appeared in the literature which routinely give good quality core and core-shell nanoparticles in terms of both monodispersity and quantum yield.

Single-source precursors have also proved useful in the synthesis of semiconductor nanoparticle materials of II-VI, as well as other, compound semiconductor nanoparticles. Bis(dialkyldithio-/diseleno-carbamato)cadmium(II) / zinc(II) compounds, M(E₂CNR₂)₂ (where M = Zn or Cd, E = S or Se and R = alkyl), have been used in a similar 'one-pot' synthetic procedure, which involved dissolving the precursor in tri-*n*-octylphosphine (TOP) followed by rapid injection into hot tri-*n-*octylphosphine oxide/tri-*n*-octylphosphine (TOPO/TOP) above 200 °C.

Fundamentally all of the above procedures rely on the principle of high temperature particle nucleation, followed by particle growth at a lower temperature. Moreover, to provide a monodispersed ensemble of nanoparticles in the 2 - 10nm range there must be proper separation of nanoparticle nucleation from nanoparticle growth. This is achieved by rapid injection of a cooler solution of one or both precursors into a hotter coordinating solvent (containing the other precursor if otherwise not present) which initiates particle nucleation. The sudden addition of the cooler solution upon injection subsequently lowers the reaction temperature (the volume of solution added is typically about 1/3 of the total solution) and inhibits further nucleation. Particle growth (being a surface catalyzed process or via Ostwald ripening depending on the precursors used) continues to occur at the lower temperature and thus nucleation and growth are separated which yields a narrow nanoparticle size distribution. This method works well for small-scale synthesis where one solution can be added rapidly to another while keeping a reasonably homogenous temperature throughout the reaction. However, on the larger preparative scales needed for commercial applications, whereby large volumes of solution are required to be rapidly injected into one another, a significant temperature differential can occur within the reaction mixture which can subsequently lead to an unacceptably large particle size distribution.

Cooney and co-workers² used a II-VI molecular cluster, [S₄Cd₁₀(SPh)₁₆] [Me₃NH]₄, to produce II-VI nanoparticles of CdS, which also involved the oxidation of surface-capping SPh- ligands by iodine. This preparative route involved the fragmentation of the majority of the II-VI clusters into ions which were consumed by the remaining II-VI ([S₄Cd₁₀(SPh)₁₆]⁴⁻) clusters which subsequently grew into II-VI nanoparticles of CdS.

Strouse and co-workers³ used a similar synthetic approach using II-VI clusters to grow II-VI nanoparticles, but employed thermolysis (lyothermal) rather than a chemical agent to initiate particle growth. Moreover, the single-source precursors ([M₁₀Se₄(SPh)₁₆][X]₄ where X = Li⁺ or (CH₃)₃NH⁺, and M = Cd or Zn) were thermolysised, whereby fragmentation of some clusters occurred followed by particle growth from scavenging of the free M and Se ions, or simply from clusters aggregating together to form, initially, larger clusters, then small nanoparticles, and ultimately, larger nanoparticles.

Both of the Cooney² and Strouse³ methods employed molecular clusters to grow nanoparticles, but used ions from the clusters to grow the larger nanoparticles, either by fragmentation of some clusters or cluster aggregation. In neither case was a separate nanoparticle precursor composition used to provide the ions required to grow the larger nanoparticle on the original molecular cluster. Moreover, neither the Cooney² nor Strouse³ methods retained the structural integrity of the original individual molecular clusters in the final nanoparticles. Furthermore, it can be seen that both of these methods are limited to forming a II-VI nanoparticle using a II-VI cluster, which is an inevitable consequence of the fact that these methods are limited to using the material of the molecular clusters to build the larger nanoparticles. The Cooney² and Strouse³ work is therefore limited in terms of the range of possible materials that can be produced using their methodology.

The applicant's published international patent applications, PCT/GB2005/001611 and PCT/GB2006/004003, describe methods of producing large volumes of high quality mono-dispersed quantum dots, which overcome many of the problems associated with earlier small-scale methods. Chemical precursors are provided in the presence of a molecular cluster compound under conditions whereby the integrity of the molecular cluster is maintained and in that way acts as a well-defined prefabricated seed or template to provide nucleation centres that react with the chemical precursors to produce high quality nanoparticles on a sufficiently large scale for industrial application.

An important distinguishing feature of the methods described in PCT/GB2005/001611 and PCT/GB2006/004003 is that conversion of the precursor composition to the nanoparticles is effected in the presence of a molecular cluster compound which retains its structural integrity throughout nanoparticle growth. Identical molecules of the cluster compound act as seeds or nucleation points upon which nanoparticle growth is initiated. In this way, a high temperature nucleation step is not necessary to initiate nanoparticle growth because suitable well-defined nucleation sites are already provided in the system by the molecular clusters. The molecules of the cluster compound act as a template to direct nanoparticle growth. 'Molecular cluster' is a term, which is widely understood in the relevant technical field, but for the sake of clarity, should be understood herein to relate to clusters of 3 or more metal atoms and their associated ligands of sufficiently well defined chemical structure such that all molecules of the cluster compound possess the same relative molecular formula. Thus the molecular clusters are identical to one another in the same way that one H₂O molecule is identical to another H₂O molecule. By providing nucleation sites which are so much more well defined than the nucleation sites employed in earlier methods, the use of the molecular cluster compound can provide a population of nanoparticles that are essentially monodispersed. A further significant advantage of this method is that it can be more easily scaled-up. Methods of producing suitable molecular cluster compounds are known within the art, examples of which can be found at the Cambridge Crystallographic Data Centre (www.ccdc.ca.ac.uk).

It will be appreciated from the foregoing discussion that many of the nanoparticle materials that have been extensively studied to date incorporate cadmium ions. There are, however, many environmental problems associated with the use of cadmium and other heavy metals such as mercury and lead based materials and so there is a need to develop non-cadmium containing nanoparticle materials. In particular, it is desirable to produce non-cadmium containing quantum dots that exhibit similar mono-dispersities and size-tuneable photoluminescent spectra to current cadmium based materials. Commercial needs also dictate that such materials should be produced in high yields on a large-scale as cheaply as possible.

An aim of the present invention is to address one or more of the problems inherent in prior art methods for the production of nanoparticle materials. A further aim is to provide new non-cadmium containing nanoparticle materials which satisfy one or more of the commercial needs set out above.

The current invention concerns III-V nanoparticles which have been grown on, and thereby incorporate, II-VI molecular clusters. A first aspect of the present invention provides a nanoparticle comprised of a molecular cluster compound incorporating ions from groups 12 and 16 of the periodic table, and a core semiconductor material provided on said molecular cluster compound, wherein the core semiconductor material incorporates ions from groups 13 and 15 of the periodic table.

A second aspect of the present invention provides a method for producing a nanoparticle comprising a molecular cluster compound incorporating ions from groups 12 and 16 of the periodic table, and a core semiconductor material provided on said molecular cluster compound, the core semiconductor material incorporating ions from groups 13 and 15 of the periodic table, the method comprising effecting conversion of a nanoparticle core precursor composition comprising first and second core precursor species containing the ions from groups 13 and 15 of the periodic table respectively to the material of the nanoparticle core in the presence of the molecular cluster compound incorporating ions from groups 12 and 16 of the periodic table under conditions permitting seeding and growth of the nanoparticle core material.

The present invention therefore provides a means by which III-V nanoparticles can be produced relatively cheaply on a large-scale.

It is preferred that the molecular cluster compound and the core semiconductor material have compatible crystal phases which permit growth of said core semiconductor material on said molecular cluster compound. Most preferably the molecular cluster compound and the core semiconductor material have the same crystal phase. In the Examples set out below zinc sulfide clusters are used to grow indium phosphide core semiconductor nanoparticles. While the inventors do not wish to be bound by any particular theory, it is postulated that the reason it has been possible to obtain ZnS cluster / InP core nanoparticles may be due to the fact that both the ZnS cluster and InP core material possess a hexagonal crystal phase, which are therefore compatible with one another and facilitates growth of a layer of InP on a ZnS cluster.

While it may have been predicted that nanoparticles incorporating a cluster of one type of material and a core of a different type of material grown on the cluster would exhibit poor quantum yields, it has surprisingly been observed that nanoparticles according to the first aspect of the present invention exhibit relatively high quantum efficiency in the range around 20 to 60 % and up to 90% after further post-preparative treatments. Moreover, it has been determined that the quantum yields can be improved still further by washing the surface of the nanoparticles with hydrogen fluoride and/or growing one or more further layers of semiconductor material, such as a II-VI material (e.g. ZnS), on the core semiconductor material.

Preferably the molecular cluster compound incorporates zinc ions. In preferred embodiments of the nanoparticles of the first aspect of the present invention the molecular cluster compound incorporates group 16 ions selected from the group consisting of sulfide ions, selenium ions and telluride ions.

The molecular cluster compound may be selected from the group consisting of [{(PPh₃)Hg}₄(SPh)₆]; (Ph₄P)₂[(SEt)₅(Br)(HgBr)₄]; (Ph₄P)₂[Hg₄(SEt)₅Br]; and [Hg₄Te₁₂][N(CH₂CH₂Et)₄]₄.

The molecular cluster compound may be selected from the group consisting of [RME^{t}Bu]₅ where M = Zn, Cd, Hg; E = S, Se, Te; R = Me, Et, Ph; [X]₄[E₄M₁₀(SR)₁₆] where M = Zn, Cd, Hg, E = S, Se, Te, X = Me₃NH⁺, Li⁺, Et₃NH⁺; [Cd₃₂S₁₄(SPh)₃₆]˙L; [Hg₁₀Se₄(SePh)(PPh₂ⁿPr)₄]; [Hg₃₂Se₁₄(SePh)₃₆]; [Cd₁₀Se₄(SePh)₁₂(PPr₃)₄]; [Cd₃₂Se₁₄(SePh)₃₆(PPh₃)₄]; [M₄(SPh)₁₂]⁺[X]₂⁻ where M = Zn, Cd, Hg, X = Me₄N⁺, Li⁺; [Zn(SEt)Et]₁₀; [MeMEiPr] where M =Zn, Cd, Hg, E = S, Se, Te; [RCdSR']₅ where R = O(ClO₃), R' = PPh₃, ⁱPr; [Cd₁₀E₄(E'Ph)₁₂(PR₃)₄] where E = Te, Se, S and separately E' = Te, Se, S; [Cd₈Se(SePh)₁₂Cl₄]²⁻; [M₄Te₁₂]⁴⁻ where M = Cd, Hg; and [Ph₁₂M₁₈Cd₁₀(PEt₃)₃] where M = Te, Se

The core semiconductor material preferably incorporates group 13 ions selected from the group consisting of aluminium ions, gallium ions and indium ions.

The group 13 ions of the core semiconductor material may be derived from a source selected from the group consisting of III-phosphines, III-(TMS)₃, III-(alkyls), III-(aryl), III-(myrisate)₃, III-(acetate)₃, III-(myrisate)(acetate)₂, III-(myrisate)₂(acetate), and III-(III)acetylacetonate. The group 13 ions of the core semiconductor material may be derived from an organometallic compound, a coordination compound, an inorganic salt, or an elemental source.

The core semiconductor material may incorporate group 15 ions selected from the group consisting of nitride ions, arsenide ions and antimonide ions.

The group 15 ions of the core semiconductor material may be derived from an organometallic compound, a coordination compound, an inorganic salt, or an elemental source.

The group 13 ions and the group 15 ions of the core semiconductor material may be derived from a single source selected from the group consisting of [(Me)₂GaN(H)^{t}Bu]₂ [H₂GaNH₂]₃ [Ph₂GaP(SiMe₃)₃Ga(Ph)₂Cl], [Et₂GaP(SiMe₃)₂]₂, [Et₂GaPEt₂]₃, [tBu₂GaPH₂]₃, [Me₂GaP(ⁱPr)₂]₃, [^{t}BuGaPAr']₂, [^{t}Bu₂GaP(H)C₅H₉]₂, Ga(As^{t}Bu₂)₃, [Et₂GaAs(SiMe₃)₂]₂, [^{t}Bu₂GaAs(SiMe₃)₂]₂, [Et₂GaSb(SiMe₃)₂]₂, [(Me₃SiCH₂)₂InP(SiMe₃)₂]₂, [R₂InP(SiMe₃)₂]₂, [Me₂InP^{t}Bu₂]₂, [Me₂InSb^{t}Bu₂]₃,

[Et₂InSb(SiMe₃)₂]₃, [Me₂InNEt₂]₂, [Et₂AlAs^{t}Bu₂]₂, [^{t}Bu₂AlSb(SiMe₃)₂]₂, [ⁿBu₂GaAs^{t}Bu₂]₂, [Me₂Ga₂As^{t}Bu₂]₂, and [Et₂GaAs^{t}Bu₂]₂.

In a preferred embodiment the nanoparticle of the first aspect of the present invention comprises a first layer comprising a first semiconductor material provided on said nanoparticle core. Any appropriate semiconductor material may be chosen for the first semiconductor material, such as but not limited to IIA-VIB materials, IIB-VIB materials, II-V materials, III-V materials, III-IV materials, III-VI materials, IV-VI materials, or materials incorporating a transition metal element or a d-block element. Preferably the first semiconductor material incorporates ions from group 12 of the periodic table, such as zinc ions. The first semiconductor material may incorporate ions from group 16 of the periodic table, such as sulfide ions, selenium ions or telluride ions.

The nanoparticle may comprise a second layer comprising a second semiconductor material provided on said first layer. Optionally, further layers or shells of semiconductor materials may be provided on the second layer. The second and any subsequent layers may be formed from any appropriate semiconductor material, such as, but not limited to IIA-VIB materials, IIB-VIB materials, II-V materials, III-V materials, III-IV materials, III-VI materials, IV-VI materials, or materials incorporating a transition metal element or a d-block element.

In a preferred method for the production of nanoparticles according to the first aspect of the present invention a seeding II-VI molecular cluster is placed in a solvent (coordinating or non-coordinating) in the presence of nanoparticle precursors to initiate particle growth. The seeding molecular cluster is employed as a template to initiate particle growth from other precursors present within the reaction solution. The molecular cluster to be used as the seeding agent can either be prefabricated or produced *in-situ* prior to acting as a seeding agent. Some precursor may or may not be present at the beginning of the reaction process along with the molecular cluster, however, as the reaction proceeds and the temperature is increased, additional amounts of precursors can be added periodically to the reaction either dropwise as a solution or as a solid.

The method concerns the conversion of a nanoparticle precursor composition to a desired nanoparticle. Suitable precursors include single-source precursors in which the two or more ions to be incorporated in to the growing nanoparticle, or multi-source precursors in which two or more separate precursors each of which contains at least one ion to be included in the growing nanoparticle. The total amount of precursor composition required to form the final desired yield of nanoparticles can be added before nanoparticle growth has begun, or alternatively, the precursor composition can be added in stages throughout the reaction.

The conversion of the precursor to the material of the nanoparticles can be conducted in any suitable solvent. It will be appreciated that it is important to maintain the integrity of the molecules of the cluster compound. Consequently, when the cluster compound and nanoparticle precursor are introduced in to the solvent the temperature of the solvent must be sufficiently high to ensure satisfactory dissolution and mixing of the cluster compound (it is not necessary that the present compounds are fully dissolved but desirable), but not so high as to disrupt the integrity of the cluster compound molecules. Once the cluster compound and precursor composition are sufficiently well dissolved in the solvent, the temperature of the solution thus formed is raised to a temperature, or range of temperatures, which is/are sufficiently high to initiate nanoparticle growth but not so high as to damage the integrity of the cluster compound molecules. As the temperature is increased further quantities of precursor are added to the reaction in a dropwise manner or as a solid. The temperature of the solution can then be maintained at this temperature or within this temperature range for as long as required to form nanoparticles possessing the desired properties.

A wide range of appropriate solvents is available. The particular solvent used is usually at least partly dependent upon the nature of the reacting species, i.e. nanoparticle precursor and/or cluster compound, and/or the type of nanoparticles which are to be formed. Typical solvents include Lewis base type coordinating solvents, such as a phosphine (e.g. TOP), a phosphine oxide (e.g. TOPO) an amine (e.g. HDA),a thiol such as octanethiol or non-coordinating organic solvents, e.g. alkanes and alkenes. If a non-coordinating solvent is used then it will usually be used in the presence of a further coordinating agent to act as a capping agent for the following reason.

If the nanoparticles, being formed, are intended to function as quantum dots it is important that the surface atoms which are not fully coordinated "dangling bonds" are capped to minimise non-radiative electron-hole recombinations and inhibit particle agglomeration which can lower quantum efficiencies or form aggregates of nanoparticles. A number of different coordinating solvents are known which can also act as capping or passivating agents, e.g. TOP, TOPO, had or long chain organic acids such as myristic acid (tetradecanoic acid), long chain amines, functionalised PEG chains but not restricted to these capping agents. If a solvent is chosen which cannot act as a capping agent then any desirable capping agent can be added to the reaction mixture during nanoparticle growth. Such capping agents are typically Lewis bases, including mono- or multi- dentate ligands of the type phosphines (trioctylphosphine, triphenolphosphine, *t*-butylphosphine), phosphine oxides (trioctylphosphine oxide), alkyl phosphonic acids, alkyl-amines (hexadecylamine, octylamine), aryl-amines, pyridines, octanethiol, a long chain fatty acid and thiophenes, but a wide range of other agents are available, such as oleic acid and organic polymers which form protective sheaths around the nanoparticles.

The outer most layer (capping agent) of a quantum dot can also consist of a coordinated ligand that processes additional functional groups that can be used as chemical linkage to other inorganic, organic or biological material, whereby the functional group is pointing away from the quantum dot surface and is available to bond/react with other available molecules, such as primary, secondary amines, alcohols, carboxylic acids, azides, hydroxyl group but not limited to. The outer most layer (capping agent) of a quantum dot can also consist of a coordinated ligand that processes a functional group that is polymerisable and can be used to form a polymer around the particle.

The outermost layer (capping agent) can also consist of organic units that are directly bonded to the outermost inorganic layer and can also possess a functional group, not bonded to the surface of the particle, that can be used to form a polymer around the particle, or for further reactions.

With regard to the method forming the second aspect of the present invention it is preferred that the molecular cluster compound incorporates zinc ions. The molecular cluster compound preferably incorporates group 16 ions selected from the group consisting of sulfide ions, selenium ions and telluride ions. The molecular cluster compound may be selected from the group consisting of [{(PPh₃)Hg}₄(SPh)₆]; (Ph₄P)₂[(SEt)₅(Br)(HgBr)₄]; (Ph₄P)₂[Hg₄(SEt)₅Br]; and [Hg₄Te₁₂][N(CH₂CH₂Et)₄]₄. Alternatively, the molecular cluster compound is selected from the group consisting of [RME^{t}Bu]₅ where M = Zn, Cd, Hg; E = S, Se, Te; R = Me, Et, Ph; [X]₄[E₄M₁₀(SR)₁₆] where M = Zn, Cd, Hg, E = S, Se, Te, X = Me₃NH⁺, Li⁺, Et₃NH⁺; [Cd₃₂S₁₄(SPh)₃₆]˙L; [Hg₁₀Se₄(SePh)(PPh₂ⁿPr)₄]; [Hg₃₂Se₁₄(SePh)₃₆]; [Cd₁₀Se₄(SePh)₁₂(PPr₃)₄]; [Cd₃₂Se₁₄(SePh)₃₆(PPh₃)₄]; [M₄(SPh)₁₂]⁺[X]₂⁻ where M = Zn, Cd, Hg, X = Me₄N⁺, Li⁺; [Zn(SEt)Et]₁₀; [MeMEiPr] where M =Zn, Cd, Hg, E = S, Se, Te; [RCdSR']₅ where R = O(ClO₃), R' = PPh₃, ⁱPr; [Cd₁₀E₄(E'Ph)₁₂(PR₃)₄] where E = Te, Se, S and separately E' = Te, Se, S; [Cd₈Se(SePh)₁₂Cl₄]²⁻; [M₄Te₁₂]⁴⁻ where M = Cd, Hg; and [Ph₁₂M₁₈Cd₁₀(PEt₃)₃] where M = Te, Se.

In the method the core semiconductor material preferably incorporates group 13 ions selected from the group consisting of aluminium ions, gallium ions and indium ions. The core semiconductor material may incorporate group 15 ions selected from the group consisting of nitride ions, arsenide ions and antimonide ions.

The first and second core precursor species may be separate entities contained in said core precursor composition. In this case, the group 13 ions of the core semiconductor material may be derived from a source selected from the group consisting of III-phosphines, III-(TMS)₃, III-(alkyls), III-(aryl), III-(myrisate)₃, III-(acetate)₃, III-(myrisate)(acetate)₂, III-(myrisate)₂(acetate), and III-(III)acetylacetonate. The group 13 ions of the core semiconductor material may be derived from an organometallic compound, a coordination compound, an inorganic salt and/or an elemental source. Moreover, the group 15 ions of the core semiconductor material may be derived from an organometallic compound, a coordination compound, an inorganic salt and/or an elemental source.

The first and second core precursor species may be combined in a single entity contained in said core precursor composition.

In the method the group 13 ions and the group 15 ions of the core semiconductor material may be derived from a single source selected from the group consisting of [(Me)₂GaN(H)^{t}Bu]₂ [H₂GaNH₂]₃ [Ph₂GaP(SiMe₃)₃Ga(Ph)₂Cl], [Et₂GaP(SiMe₃)₂]₂, [Et₂GaPEt₂]₃, [tBu₂GaPH₂]₃, [Me₂GaP(ⁱPr)₂]₃, [^{t}BuGaPAr']₂, [^{t}Bu₂GaP(H)C₅H₉]₂, Ga(As^{t}Bu₂)₃, [Et₂GaAs(SiMe₃)₂]₂, [^{t}Bu₂GaAs(SiMe₃)₂]₂, [Et₂GaSb(SiMe₃)₂]₂, [(Me₃SiCH₂)₂InP(SiMe₃)₂]₂, [R₂InP(SiMe₃)₂]₂, [Me₂InP^{t}Bu₂]₂, [Me₂InSb^{t}Bu₂]₃, [Et₂InSb(SiMe₃)₂]₃, [Me₂InNEt₂]₂, [Et₂AlAs^{t}Bu₂]₂, [^{t}Bu₂AlSb(SiMe₃)₂]₂, [ⁿBu₂GaAs^{t}Bu₂]₂, [Me₂Ga₂As^{t}Bu₂]₂, and [Et₂GaAs^{t}Bu₂]₂.

The method may further comprise forming a first layer comprised of a first semiconductor material on the nanoparticle core material. Preferably formation of the first layer of the first semiconductor material comprises effecting conversion of a first material precursor composition to said first material. It is preferred that the first material precursor composition comprises third and fourth ions to be incorporated into the layer comprised of the first material. The third and fourth ions may be separate entities contained in the first material precursor composition or may be combined in a single entity contained in the first material precursor composition.

It is preferred that the nanoparticle core material is exposed to hydrogen fluoride prior to formation of the first layer of the first semiconductor material. Etching the surface of the nanoparticle cores with a solution comprising hydrogen fluoride may increase the quantum efficiency of the nanoparticles, as discussed in more detail below in the Examples.

The present invention concerns III-V nanoparticles produced using II-VI molecular clusters, whereby the clusters are well defined identical molecular entities, as compared to ensembles of small nanoparticles, which inherently lack the anonymous nature of molecular clusters. A II-VI molecular cluster is used instead of a III-V cluster as there are few known III-V molecular clusters, III-V molecular clusters are difficult to make and are generally air and moisture sensitive, whereas there is a large number of II-VI molecular clusters that can be made by simple procedure with many of the clusters not being air and moisture sensitive. III-V particles can be seeded on a number of II-VI molecular clusters and so for the first time it is now appreciated that there is no requirement or advantage of using a III-V molecular cluster to grow a III-V nanoparticle. By using a molecular cluster there is no need for a high temperature nucleation step as in the conventional method of producing III-V quantum dots, which means large-scale synthesis is possible.

Moreover, it is possible to use a II-VI molecular cluster such as [HNEt₃]₄[Zn₁₀S₄(SPh)₁₆] to seed the growth of III-V nanoparticle materials such as InP and GaP quantum dots and their alloys. Following addition or formation *in situ* of the II-VI molecular cluster, molecular sources of the III and V ions, "molecular feedstocks", are added and consumed to facilitate particle growth. These molecular sources may be periodically added to the reaction solution so as to keep the concentration of free ions to a minimum whilst maintaining a concentration of free ions to inhibit Ostwald's ripening from occurring and defocusing of nanoparticle size range from occurring.

Nanoparticle growth may be initiated by heating (thermolysis) or by solvothermal means. The term solvothermal shall be used herein to refer to heating in a reaction solution so as to initiate and sustain particle growth and is intended to encompass the processes which are also sometimes referred to as thermolsolvol, solution-pyrolysis, and lyothermal. Particle preparation can also be accomplished by changing the reaction conditions, such as adding a base or an acid, elevation of pressures, i.e. using pressures greater than atmospheric pressure, application of electromagnetic radiation, such as microwave radiation or any one of a number of other methods known to the skilled person.

### Conditions For The Preparation Of III-V Semiconductor Quantum Dots

### Feedstocks

The molecular feedstocks can be in the form of a single-source precursor whereby all elements required within the as to be growth nanoparticle are present within a single compound precursor or a combination of precursors each containing one or more element/ion required within the as to be grown nanoparticles. These feedstocks may be added at the beginning of the reaction or periodically throughout the reaction of particle growth. This feedstock can be in the form of liquids, solutions, solids, slurries or gases.

### In-Situ Formation Of Seeding Cluster

The cluster to be employed as the seeding template may be prefabricated prior to the reaction and added to the reaction solution at the beginning of the reaction process or formed *in-situ* in the reaction solution prior to the addition of precursors used for the growth of the nanoparticles.

### Type Of System To Be Made

### Semiconductor Core Materials

The present invention is directed to the preparation of III-V nanoparticulate materials and their alloys and includes compound semiconductor particles otherwise referred to as quantum dots or nanocrystals, which typically fall within the size range 2 - 100 nm and include nanoparticle core material comprising:

III-V material including a first element from group 13 (III) of the periodic table and a second element from group 15 (V) of the periodic table, as well as ternary, quaternary and doped materials.

Preferred examples of nanoparticle core materials include but are not restricted to: BP, AlP, AlAs, AlSb; GaN, GaP, GaAs, GaSb; InN, InP, InAs, InSb, AlN and BN. Nanoparticles falling within the first aspect of the present invention include not only binary phase materials incorporating III and V ions, but also ternary and quaternary phase nanoparticles incorporating respectively one or two further types of ions in addition to the III and V ions which are present. It will be appreciated that ternary phase nanoparticles consist of three component materials and quaternary phase nanoparticles consist four-component materials.

Doped nanoparticles refer to nanoparticles of the above type which further incorporate a dopant comprised of one or more main group or rare earth elements, most often a transition metal or rare earth element, such as, but not limited to, Mn⁺ or Cu²⁺.

### Outer Inorganic Shell Or Shells

The material used on any shell or subsequent numbers of shells grown onto the core III-V nanoparticle in most cases will be of a similar lattice type material to the core material i.e. have close lattice match to the core material so that it can be epitaxially grown on to the core, but is not necessarily restricted to materials of this compatibility. However, if the two materials, core and shell, are incompatible a buffer layer may be grown first on the outside of the core, between the semiconductor core and semiconductor shell. The material of any buffer layer or shell layer grown on to the core can include material comprising of:

IIA-VIB (2-16) material, incorporating a first element from group 2 of the periodic table and a second element from group 16 of the periodic table and also including ternary and quaternary materials and doped materials. Nanoparticle material includes but is not restricted to: MgS, MgSe, MgTe, CaS, CaSe, CaTe, SrS, SrSe, SrTe.

IIB-VIB (12-16) material incorporating a first element from group 12 of the periodic table and a second element from group 16 of the periodic table and also including ternary and quaternary materials and doped materials. Nanoparticle material includes but is not restricted to: ZnS, ZnSe, ZnTe, CdS, CdSe, CdTe, HgS, HgSe, HgTe.

II-V material incorporating a first element from group 12 of the periodic table and a second element from group 15 of the periodic table and also including ternary and quaternary materials and doped materials. Nanoparticle material includes but is not restricted to: Zn₃P₂, Zn₃As₂, Cd₃P₂, Cd₃As₂, Cd₃N₂, Zn₃N₂.

III-V material incorporating a first element from group 13 of the periodic table and a second element from group 15 of the periodic table and also including ternary and quaternary materials and doped materials. Nanoparticle material include but is not restricted to: BP, AlP, AlAs, AlSb; GaN, GaP, GaAs, GaSb; InN, InP, InAs, InSb, AlN, BN.

III-IV material incorporating a first element from group 13 of the periodic table and a second element from group 14 of the periodic table and also including ternary and quaternary materials and doped materials. Nanoparticle material includes but is not restricted to: B₄C, Al₄C₃, Ga₄C.

III-VI material incorporating a first element from group 13 of the periodic table and a second element from group 16 of the periodic table and also including ternary and quaternary materials. Nanoparticle material include but is not restricted to: Al₂S₃, Al₂Se₃, Al₂Te₃, Ga₂S₃, Ga₂Se₃,; In₂S₃, In₂Se₃, Ga₂Te₃, In₂Te₃.

IV-VI material incorporating a first element from group 14 of the periodic table and a second element from group 16 of the periodic table and also including ternary and quaternary materials and doped materials. Nanoparticle material includes but is not restricted to: PbS, PbSe, PbTe, Sb₂Te₃, SnS, SnSe, SnTe.

Nanoparticle material incorporating a first element from any group in the transition metal of the periodic table, and a second element from any group of the d-block elements of the periodic table and also including ternary and quaternary materials and doped materials. Nanoparticle material includes but is not restricted to: NiS, CrS, CuInS₂, CuInSe₂, CuGaS₂, CuGaSe₂.

### Nanoparticle Shape

The shape of the nanoparticle is not restricted to a sphere and can take any desirable shape, for example, a rod, sphere, disk, tetrapod or star. The control of the shape of the nanoparticle can be achieved in the reaction particle growth process by the addition of a compound that will preferentially bind to a specific lattice plane of the growing particle and subsequently inhibit or slow particle growth in a specific direction. Non-limiting examples of compounds that can be added to achieve this effect include: phosphonic acids (*n*-tetradecylphosphonic acid, hexylphosphonic acid, 1-decanesulfonic acid, 12-hydroxydodecanoic acid, *n*-octadecylphosphonic acid).

### General Description Of Preparative Procedure

The current invention is intended to provide substantially pure, monodispersed, nanocrystalline particles that may be stabilized from particle aggregation and the surrounding chemical environment by a capping agent such as a coordinating organic layer. A suitable formula representing such nanoparticles is MEₙL_{y} where M = group III element, E = group V element, L = ligand e.g. coordinating organic layer/capping agent, and n and y represent the appropriate stoichiometric amounts of components E and L.

The first step for preparing nanoparticles of a semiconductor material is to use a molecular cluster as a template to seed the growth of nanoparticles from other element source precursors. This is achieved by mixing a small quantity of a cluster which is to be used as the template with a high boiling point solvent which can also be the capping agent, being a Lewis base coordination compound such as but not restricted to a phosphine, a phosphine oxide, amines or organic acids; or an inert solvent such as an alkane (octadecence) with the addition of a capping agent compound such as oleic acid. As the reaction temperature is increased source precursors of M and E are periodically added either dropwise when in liquid from or as quantities of solid powder. Further to this a source for M and a source for E are added to the reaction mixture. The M and E precursor source can either be in the form of two separate precursors one containing M and the other containing E or as a single-source precursor that contains both M and E within a single molecule.

Further to this other regents may or may not be added to the reactions which have the ability to control the shape of the nanoparticles grown. These additives are in the form of a compound that can preferentially bind to a specific face (lattice plane) of the growing nanoparticle and thus inhibit or slow particle grow along that specific direction of the particle. Other element source precursors may or may not be added to the reaction so as to produce ternary, quaternary or doped particles.

The molecular cluster is mixed with coordinating compound and the reaction mixture is then heated at a steady rate until particle growth is initiated upon the surfaces of the molecular cluster-templates. At an appropriate temperature further quantities of M and E precursors may be added to the reaction mixture. Further precursor addition can be in the form of batch addition whereby solid precursors are added or solutions containing precursor are added over a period of time or by continuous dropwise addition of the solution phase precursors. Because of the complete separation of particle nucleation and growth, the current invention displays a high degree of control in terms of particle size, which is controlled by the temperature of the reaction and concentrations of precursors present. Once the desired particle size is obtained, as established from UV and/or PL spectra of the reaction solution either by an *in situ* optical probe or from aliquots of the reaction solution, the temperature may or may not be reduced by a specific amount and the mixture left to anneal for a period of time being from 10 minutes to 72 hours.

Further consecutive treatment of the as formed nanoparticles to form ME/NY core-shell or core-multi shell particles may be undertaken. Core-shell particle preparation is undertaken either before or after nanoparticle isolation, whereby the nanoparticles are isolated from the reaction and redissolved in new (clean) capping agent, either the same capping agent compound or a different capping agent compound, as this can result in a better quality quantum dots. A source for N and a source for Y precursor (N and Y being elements required in the shell or layer being grown on the ME core quantum dot) are added to the reaction mixture and can be either in the form of two separate precursors one containing N and the other containing Y, or as a single-source precursor that contains both N and Y within a single molecule to form a core-shell particle of ME/NY core-shell material.

The process may be repeated with the appropriate element precursors until the desired core-multi shell material is formed. The nanoparticles size and size distribution in an ensemble of particles is dependent on the growth time, temperature and concentrations of reactants in solution, with higher temperatures producing larger nanoparticles.

### Type Of Cluster Used For Seeding

The invention includes the use of II-VI molecular clusters, whereby the clusters used are identical molecular entities as compared to nanoparticles, which inherently lack the anonymous nature of molecular clusters in an assembly. The clusters act as "embryo-type" templates for the growth of nanoparticles whereby other molecular sources precursors contribute ions to the growth process and thus clusters subsequently grow into particles.

The molecular clusters incorporate a first ion from group 12 of the periodic table and a second ion from group 16 of the periodic table.

The group 12 ion may be selected from the group consisting of zinc, cadmium or mercury.

The group 16 ion may be selected from the group consisting of sulfur, selenium and tellurium.

Preferred embodiments of molecular clusters that can be used but not restricted to are:

### IIB-VIB

[{(PPh₃)Hg}₄(SPh)₆]
(Ph₄P)₂[(SEt)₅(Br)(HgBr)₄]
(Ph₄P)₂[Hg₄(SEt)₅Br]
[Hg₄Te₁₂][N(CH₂CH₂Et)₄]₄

### IIB-VIB

[RME^{t}Bu]₅ where M = Zn, Cd, Hg; E = S, Se, Te; R = Me, Et, Ph
[X]₄[E₄M₁₀(SR)₁₆] where M = Zn, Cd, Hg; E = S, Se, Te, X = Me₃NH⁺, Li⁺, Et₃NH⁺
[Cd₃₂S₁₄(SPh)₃₆]˙L
[Hg₁₀Se₄(SePh)(PPh₂ⁿPr)₄]
[Hg₃₂Se₁₄(SePh)₃₆]
[Cd₁₀Se₄(SePh)₁₂(PPr₃)₄]
[Cd₃₂Se₁₄(SePh)₃₆(PPh₃)₄]
[M₄(SPh)₁₂]⁺[X]₂⁻ where M = Zn, Cd, Hg; X = Me₄N⁺, Li⁺
[Zn(SEt)Et]₁₀
[MeMEiPr] where M =Zn, Cd, Hg; E = S, Se, Te
[RCdSR']₅ where R = O(ClO₃), R' = PPh₃, ⁱPr
[Cd₁₀E₄(E'Ph)₁₂(PR₃)₄] where E = Te, Se, S and separately E' = Te, Se, S
[Cd₈Se(SePh)₁₂Cl₄]²⁻
[M₄Te₁₂]⁴⁻ where M = Cd, Hg
[Ph₁₂M₁₈Cd₁₀(PEt₃)₃] where M = Te, Se

### Precursors Used For The Inorganic Core

### III Ion Source

III-phosphines, III-(TMS)₃, III-(alkyls), III-(aryl), III-(myrisate)₃, III-(acetate)₃, III-(myrisate)(acetate)₂, III-(myrisate)₂(acetate), III-(III)acetylacetonate.

Organometallic compounds, such as but not restricted to MR₃ where M = Ga, In, Al, B; R = alky or aryl group, for example AlR₃, GaR₃, InR₃ (R = Me, Et, ⁱPr).

Coordination compounds, such as carbonate, M(CH₃C)₃ where M = B, Al, Ga, In: β-diketonate or derivative thereof, such as acetylacetonate (2,4-pentanedionate) M[CH₃COOCH=C(O-)CH₃]₂ where M = B, Al, Ga, In.

Inorganic salts, such as an oxide (e.g. In₂O₃, Ga₂O₃) or a nitrate (e.g. Al(NO₃)₃, In(NO₃)₃, Ga(NO₃)₃).

Elemental sources, such as B, Al, Ga, In.

### V Ion Source

Organometallic compounds, such as but not restricted to NR₃, PR₃, AsR₃, SbR₃ (R=Me, Et, ^{t}Bu, ⁱBu, Prⁱ, Ph etc.); NHR₂, PHR₂, AsHR₂, SbHR₂ (R=Me, Et, ^{t}Bu, ⁱBu, Prⁱ, Ph etc.); NH₂R, PH₂R, AsH₂R, SbH₂R₃ (R=Me, Et, ^{t}Bu, ⁱBu, Prⁱ, Ph etc.); PH₃, AsH₃; M(NMe)₃ M = P, Sb, As; dimethyldrazine (Me₂NNH₂); ethylazide (Et-NNN); hydrazine (H₂NNH₂); Me₃SiN₃.

Coordination compound such as but not restricted to a carbonate, MCO₃ M = P, bismuth subcarbonate (BiO)₂CO₃; a β-diketonate or derivative thereof, such as acetylacetonate (2,4-pentanedionate) [CH₃COOCH=C(O-)CH₃]₃M M = Bi; [CH₃COOCH=C(O-)CH₃]₂M.

Inorganic salts, such as oxides P₂O₃, As₂O₃, Sb₂O₃, Sb₂O₄, Sb₂O₅, Bi₂O₃, or nitrates Bi(NO₃)₃, Sn(NO₃)₄, Pb(NO₃)₂.

Elemental sources, such as N, P, As, Sb, Bi.

### Combined III-V Ion Sources - ME Single Source Precursors

For a compound semiconductor nanoparticle comprising III-V elements the III and V ions can also be in the form of a single-source precursor, whereby the precursor to be used contains both M and E within a single molecule.

The single source precursor can be an organometallic compound, an inorganic salt or a coordination compound, (MₐE_{b})L_{c} where M and E are the elements required within the nanoparticles, L is the capping ligand, and a, b and c are numbers representing the appropriate stroichiometry of M, E and L.

For III-V core semiconductors the singles source precursors can be, but are not restricted to:
for GaN: [(Me)₂GaN(H)^{t}Bu]₂ [H₂GaNH₂]₃;
for GaP: [Ph₂GaP(SiMe₃)₃Ga(Ph)₂Cl], [Et₂GaP(SiMe₃)₂]₂, [Et₂GaPEt₂]₃,
[^{t}Bu₂GaPH₂]₃, [Me₂GaP(ⁱPr)₂]₃ [^{t}BuGaPAr']₂, [^{t}Bu₂GaP(H)C₅H₉]₂;
forGaAs: Ga(As^{t}Bu₂)₃, [Et₂GaAs(SiMe₃)₂]₂, [^{t}Bu₂GaAs(SiMe₃)₂]₂;
for GaSb: [Et₂GaSb(SiMe₃)₂]₂;
for InP: [(Me₃SiCH₂)₂InP(SiMe₃)₂]₂, [R₂InP(SiMe₃)₂]₂, [Me₂InP^{t}Bu₂]₂;
for InSb: [Me₂InSb^{t}Bu₂]₃, [Et₂InSb(SiMe₃)₂]₃, [Me₂InNEt₂]_{2,} [Et₂AlAs^{t}Bu₂]₂;
for AlSb: [^{t}Bu₂AlSb(SiMe₃)₂]₂;
for GaAs: [ⁿBu₂GaAs^{t}Bu₂]₂, [Me₂Ga₂As^{t}Bu₂]₂, [Et₂GaAs^{t}Bu₂]₂.

### Precursors Used For Any Outer Inorganic Shell Or Subsequent Shells (ME)

For a compound core/shell semiconductor nanoparticle consisting of a III-V core and an MEₙLₘ shell (where M and E are the elements in the shell or subsequent shell layer) a source for element M may be further added to the reaction and can consist of any E-containing species that has the ability to provide the growing particles with a source of E ions.

### M Source

The precursor can consist of, but is not restricted to, an organometallic compound, an inorganic salt, a coordination compound or an elemental source. Examples for II-VI, III-V, III-VI or IV-V for the first element include, but are not restricted to:

Organometallic such as but not restricted to a MR₂ where M = Mg R = alky or aryl group (Mg^{t}Bu₂); MR₂ where M = Zn, Cd, Te; R = alky or aryl group (Me₂Zn, Et₂Zn Me₂Cd, Et₂Cd); MR₃ where M = Ga, In, Al, B; R = alky or aryl group [AlR₃, GaR₃, InR₃ (R=Me, Et, ⁱPr)].

Coordination compound such as a carbonate but not restricted to a MCO₃ M = Ca, Sr, Ba, [magnesium carbonate hydroxide (MgCO₃)₄·Mg(OH)₂]; M(CO₃)₂ M = Zn, Cd,; MCO₃ M = Pb: acetate: M(CH₃CO₂)₂ M = Mg, Ca, Sr, Ba; Zn, Cd, Hg; M(CH₃C)₃ M = B, Al, Ga, In: a β-diketonate or derivative thereof, such as acetylacetonate (2,4-pentanedionate) [CH₃COOCH=C(O-)CH₃]₂ M = Mg, Ca, Sr, Ba, Zn, Cd, Hg; [CH₃COOCH=C(O-)CH₃]₂ M = B, Al, Ga, In. Oxalate SrC₂O₄, CaC₂O₄, BaC₂O₄, SnC₂O₄.

Inorganic salt such as but not restricted to a Oxides SrO, ZnO, CdO, In₂O₃, Ga₂O₃, SnO₂, PbO₂; Nitrates Mg(NO₃)₂, Ca(NO₃)₂, Sr(NO₃)₂, Ba(NO₃)₂, Cd(NO₃)₂, Zn(NO₃)₂, Hg(NO₃)₂, Al(NO₃)₃, In(NO₃)₃, Ga(NO₃)₃, Sn(NO₃)₄, Pb(NO₃)₂

Elemental sources, such as but not restricted to Mg, Ca, Sr, Ba, Zn, Cd, Hg, B, Al, Ga, In, Sn, Pb.

### E Source

A source for element E may be further added to the reaction and can consist of any E-containing species that has the ability to provide the growing particles with a source of E ions.

The precursor can consist of, but is not restricted to, an organometallic compound, an inorganic salt, a coordination compound or an elemental source. Examples for element E in a II-VI, III-V, III-VI or IV-V semiconductor nanoparticle include, but are not restricted to:

Organometallics, such as but not restricted to: NR₃, PR₃, AsR₃, SbR₃ (R=Me, Et, ^{t}Bu, ¹Bu, Prⁱ, Ph etc.); NHR₂, PHR₂, AsHR₂, SbHR₂ (R=Me, Et, ^{t}Bu, ⁱBu, Prⁱ, Ph etc.); NH₂R, PH₂R, AsH₂R, SbH₂R₃ (R=Me, Et, ^{t}Bu, ⁱBu, Prⁱ, Ph etc.); PH₃, AsH₃; M(NMe)₃ M = P, Sb, As; dimethyldrazine (Me₂NNH₂); ethylazide (Et-NNN); hydrazine (H₂NNH₂); Me₃SiN₃.

MR₂ (M = S, Se Te; R=Me, Et, ^{t}Bu, ⁱBu etc.); HMR (M = S, Se Te; R=Me, Et, ^{t}Bu, ¹Bu, ¹Pr, Ph etc); thiourea S=C(NH₂)₂; Se=C(NH₂)₂.

Sn(CH₄)₄, Sn(C₄H₉), Sn(CH₃)₂(OOCH₃)₂.

Coordination compounds, such as but not restricted to a carbonate, MCO₃ M = P, bismuth subcarbonate (BiO)₂CO₃; M(CO₃)₂; acetate M(CH₃CO)₂ M = S, Se, Te: M(CH₃C)₃ M = Sn, Pb: a β-diketonate or derivative thereof, such as acetylacetonate (2,4-pentanedionate) [CH₃COOCH=C(O-)CH₃]₃M M = Bi; [CH₃COOCH=C(O-)CH₃]₂M M = S, Se, Te: [CH₃COOCH=C(O-)CH₃]₂M M = Sn, Pb: thiourea, selenourea (H₂NC(=Se)NH₂.

Inorganic salts, such as but not restricted to oxides P₂O₃, As₂O₃, Sb₂O₃, Sb₂O₄, Sb₂O₅, Bi₂O₃, SO₂, SeO₂, TeO₂, Sn₂O, PbO, PbO₂; Nitrates Bi(NO₃)₃, Sn(NO₃)₄, Pb(NO₃)₂

Elemental sources: Sn, Ge, N, P, As, Sb, Bi, S, Se, Te, Sn, Pb.

### Combined III-V Ion Sources - ME Single Source Precursors

For a compound semiconductor nanoparticle shell of formula ME, elements M and E can be provided by a single-source precursor, whereby the precursor to be used contains both M and E within a single entity. This precursor can be an organometallic compound, inorganic salt or a coordination compound, (MₐE_{b})L_{c} where M and E are the elements required within the nanoparticles, L is the capping ligand, and a, b and c are the appropriate stoichiometric values.

Non-limiting examples for a II-VI semiconductor shell where M is a group II ion and E is a group VI ion, include bis(dialkyldithio-carbamato)M,(II) complexes or related Se and Te compounds of the formula M(S₂CNR₂)₂ where M = Zn, Cd, Hg; S = S, Se, O, Te and R = alkyl or aryl groups; CdS Cd[SSiMe₃]₂, Cd(SCNHNH₂)₂Cl₂, Cd(SOCR)₂·py; CdSe [Cd(SePh)₂]₂.

For III-V semiconductor shells, non-limiting examples of ME single source precursors include:
for GaN: [(Me)₂GaN(H)^{t}Bu]₂, [H₂GaNH₂]₃;
for GaP: [Ph₂GaP(SiMe₃)₃Ga(Ph)₂Cl], [Et₂GaP(SiMe₃)₂]₂, [Et₂GaPEt₂]₃,
[^{t}Bu₂GaPH₂]₃ [Me₂GaP(ⁱPr)₂]₃, [^{t}BuGaPAr']₂, [^{t}Bu₂GaP(H)C₅H₉]₂;
forGaAs: Ga(As^{t}Bu₂)₃, [Et₂GaAs(SiMe₃)₂]₂, [^{t}Bu₂GaAs(SiMe₃)₂]₂;
for GaSb: [Et₂GaSb(SiMe₃)₂]₂;
for InP: [(Me₃SiCH₂)₂InP(SiMe₃)₂]₂, [R₂InP(SiMe₃)₂]₂, [Me₂InP^{t}Bu₂]₂;
for InSb: [Me₂InSb^{t}Bu₂]₃, [Et₂InSb(SiMe₃)₂]₃, [Me₂InNEt₂]₂, [Et₂AlAs^{t}Bu₂]₂;
for AlSb: [^{t}Bu₂AlSb(SiMe₃)₂]₂;
for GaAs: [ⁿBu₂GaAs^{t}Bu₂]₂, [Me₂Ga₂As^{t}Bu₂]₂, [Et₂GaAs^{t}Bu₂]₂.

For II-V semiconductor shells, non-limiting examples of ME single source precursors include:
for Cd₃P₂: [MeCdP*^{t}*Bu₂]₃, Cd[P(SiPh₃)₂]₂, Zn₃P₂, Zn[P(SiPh₃)₂]₂.

For IV-VI semiconductor shells, non-limiting examples of ME single source precursors include:
for PbS: lead (II) dithiocarbamates; and
for PbSe: lead (II)selenocarbamates.

The present invention will now be demonstrated with reference to the following non-limiting Examples, and with reference to the following figures in which:

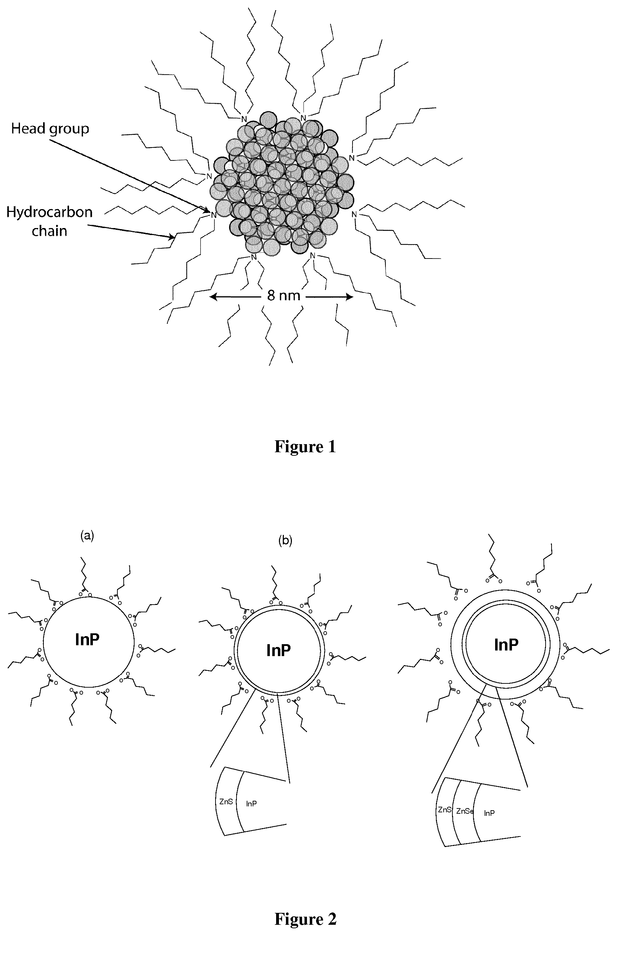

**Figure 1** is a schematic representation of a nanoparticle coated with a surfactant, the surfactant head groups having a strong affinity for the nanocrystals and the hydrocarbon chain of the surfactant helping to solubilise and disperse the nanocrystals in solvents;
**Figure 2** is a schematic representation of, a) particle consisting of a semiconductor InP core, b) particle consisting of a semiconductor InP core and semiconductor ZnS shell, c) particle consisting of a semiconductor InP core a buffer layer of a different semiconductor material, ZnSe, and an outer semiconductor ZnS shell;

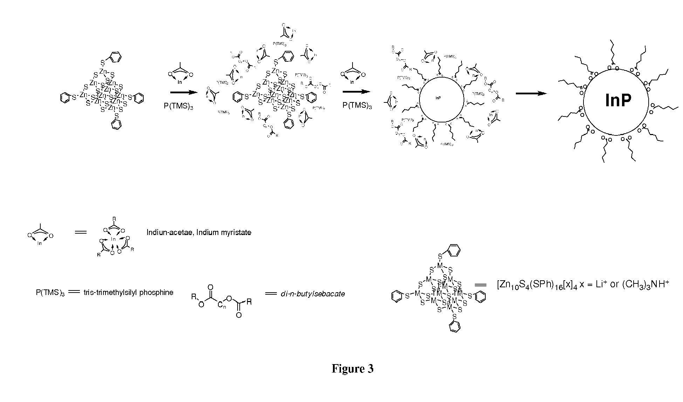

**Figure 3** is a schematic representation of the formation of an Indium phosphide quantum dot using [Zn₁₀S₄(SPh)₁₆][X]₄ x = Li⁺ or (CH₃)₃NH⁺as the molecular seed and dropwise addition of cadmium acetate and tri-n-octylphosphine selenides the cadmium and selenium element-source precursors and with Hexadecylamine used as the capping agent;

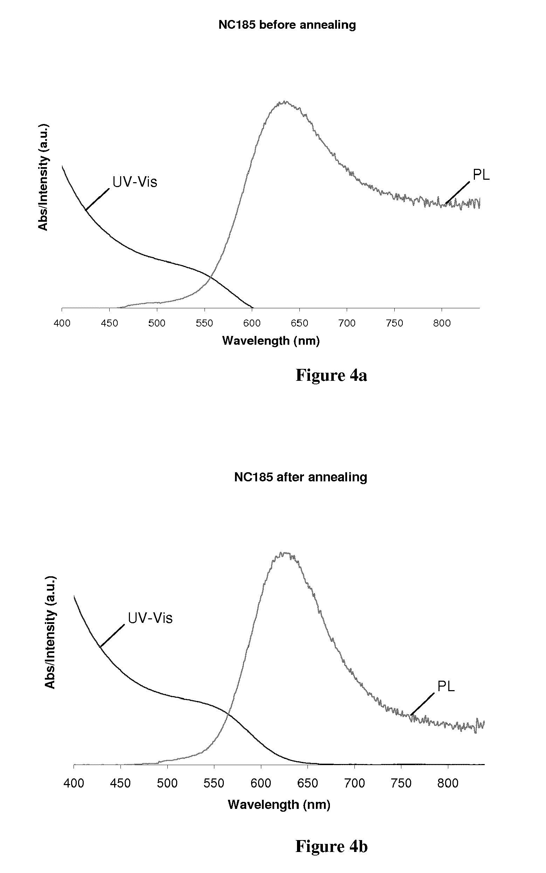

**Figure 4** shows UV and PL emission spectra of InP quantum dots a) after isolation from a reaction mixture before thermal annealing b) after thermal annealing;

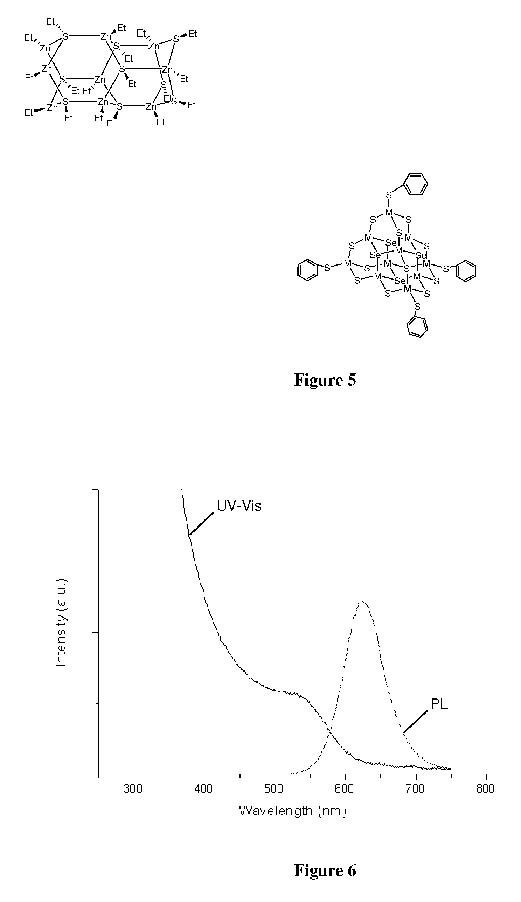

**Figure 5** illustrates molecular clusters that can be used as seeding templates; and
**Figure 6** shows UV and PL emission spectra of InP/ZnS quantum dots after isolation from a reaction mixture.

### EXAMPLES

All syntheses and manipulations were carried out under a dry oxygen-free argon or nitrogen atmosphere using standard Schlenk and glove box techniques. All solvents were analytical grade and distilled from appropriate drying agents prior to use (Na/K-benzophenone for THF, Et₂O, toluene, hexanes, pentane; magnesium for methanol and ethanol and calcium hydride for acetone). All chemicals were analytical grade.

Elemental analyses were performed on a CARLO ERBA CHNS-O EA1108•Elemental Analyzer. UV-Vis absorption spectra were measured on a Heλiosβ Thermospectronic. Photoluminescence (PL) spectra were measured with a Fluorolog-3 (FL3-22) photospectrometer with an excitation wavelength of 380 nm spectra were obtained with the slits set at 2 nm and an integration time of 1 s or measured *in situ* using an Ocean Optics 2000 USB probe. Powder X-Ray diffraction (PXRD) measurements were performed on a Bruker AXS D8 diffractometer using monochromatic Cu-K_{α} radiation with the samples mounted flat and scanned from 10° to 70° with step sizes of 0.04° with a count rate of 2.5 sec. Measurements were taken using a glancing angle incidence detector at an angle of 3° for 2θ values over 20°-60° in steps of 0.04° with a count time of 1 s. A Philips CM200 transmission electron microscope was used to observe the morphology and size distribution of nanoparticles and for energy dispersive analysis of X-ray fluorescence (EDAX). The samples for TEM and EDAX were prepared by placing a drop of a dilute suspension of sample in toluene on a copper grid (300 meshes, Agar Scientific). The excess solvent was allowed to dry at room temperature.

### General procedure

A II-VI cluster, such as [HNEt₃]₄[Zn₁₀S₄(SPh)₁₆], and small quantities of "feedstock" precursors i.e. a group III precursor such as In(myrisate)₃ and a group V element precursor such as P(TMS)₃ are used as feedstock precursors and added to a solution containing a capping agent, the temperature is then increased and the reaction stirred for a period of time which results in the on set of III-V particle formation.

Further dropwise addition of both the feedstock precursors leads to a red shift of the PL emission maximum, of the quantum dots, as monitored by an *in situ* PL probe. If further precursor is added at this stage there is no further red shift of the PL maximum, thus the particles do not grow anymore. However, when the temperature is increased (5 - 40°C) the PL maximum is again red shifted. When more precursors are added to the reaction solution the PL maxima red shifts again. Therefore, this cycle of addition of precursor followed by incrementally increasing the reaction temperature can be repeated until the PL maxima peak is at the desired emission. The reaction is then cooled to a lower temperature and allowed to anneal for a further period of time, after which III-V nanoparticles incorporating II-VI clusters can be isolated.

### Choice of molecular cluster

A II-VI molecular cluster is used instead of a III-V cluster as there are few known III-V molecular clusters, III-V molecular clusters are difficult to make and are generally air and moisture sensitive, whereas there is a large number of II-VI molecular clusters that can be made by simple procedures and II-VI clusters are not air and moisture sensitive. III-V particles can therefore be seeded on a II-VI molecular cluster, and so it can now be appreciated for the first time that there is no reason or advantage of using a III-V molecular cluster to grow III-V nanoparticles.

### EXAMPLE 1

### Preparation of InP nanoparticles (red emission)

Di-n-butylsebacate ester (200ml) and myristic acid (10g) at 60°C were placed in a round-bottomed three-neck flask and purged with N₂ followed by the addition of ZnS cluster [HNEt₃]₄[Zn₁₀S₄(SPh)₁₆] (0.94g). The reaction mixture was then heated to 100°C for 30 minutes followed by the addition of [In₂(Ac)₃(MA)₃] (0.25M, 12ml) over a period of 15 minutes using an electronic syringe pump at a rate of 48ml/hr. This was followed by the addition of (TMS)₃P (0.25M, 12ml) at the same addition rate. Once additions were complete the temperature of the reaction was increased to 180°C and further additions of [In₂(Ac)₃(MA)₃] and (TMS)₃P were made as followed: [In₂(Ac)₃(MA)₃] (16ml) followed by (TMS)₃P (16ml) were added followed by a temperature increase to 200°C then further additions of [In₂(Ac)₃(MA)₃] (10ml), to grow the particles up to the required size and thus the required emission in the red. The temperature was then left for 1 hr 200°C then lowered to 160°C and the reaction mixture then allowed to anneal for 3 days. The particles were isolated using acetonitrile, centrifuged and collected. The particles exhibited a quantum efficiency of 5-60 %.

### EXAMPLE 2

### Preparation of InP quantum dots with emission ranging from 500 - 700nm and growth of a ZnS shell

Di-butyl ester (100ml) and Myristic acid (10.0627g) were placed in a three-neck flask and degassed at 70°C under vacuum for one hour. After this period, nitrogen was introduced and the temperature increased to 90°C. ZnS molecular cluster [Et₃NH₄][Zn₁₀S₄(SPh)₁₆] (4.7076g) was added and the mixture allowed to stir for 45 minutes. The temperature was then increased to 100°C followed by the dropwise addition of In(MA)₃ (1M, 15ml) followed by (TMS)₃P (1M, 15ml). The reaction mixture was allowed to stir while increasing the temperature to 140°C. At 140°C, further dropwise additions of In(MA)₃ (1M, 35ml) (left to stir for 5 minutes) and (TMS)₃P (1M, 35ml) were made. The temperature was then slowly increased to 180°C and further dropwise additions of In(MA)₃ (1M,55ml) followed by (TMS)₃P (1M, 40ml) were made. By addition of the precursor in the manner above nanoparticles of InP could be grown with the emission maximum gradually increasing from 520nm up to 700nm, whereby the reaction can be stopped when the desired emission maximum has been obtained and left to stir at this temperature for half an hour. After this period, the temperature was decreased to 160°C and the reaction mixture was left to anneal for up to 4 days (at a temperature between 20 - 40°C below that of the reaction). A UV lamp was also used at this stage to aid in annealing.

The nanoparticles were isolated by the addition of dried degassed methanol (approx. 200 ml) via cannula techniques. The precipitate was allowed to settle and then methanol was removed via cannula with the aid of a filter stick. Dried degassed chloroform (approx. 10 ml) was added to wash the solid. The solid was left to dry under vacuum for 1 day. This produced 5.60 g of InP core nanoparticles. Elemental analysis: max PL = 630 nm, FWHM = 70 nm.

### Postoperative treatments

The quantum yields of the InP quantum dots prepared above were increased by washing with dilute HF acid. The dots were dissolved in anhydrous degassed chloroform (~270ml). A 50ml portion was removed and placed in a plastic flask, flushed with nitrogen. Using a plastic syringe, the HF solution was made up by adding 3ml of 60% w/w HF in water and adding to degassed THF (17ml). The HF was added dropwise over 5hrs to the InP dots. After addition was complete the solution was left to stir overnight. Excess HF was removed by extracting through calcium chloride solution in water and drying the etched InP dots. The dried dots were re-dispersed in 50ml chloroform for future use. Max 567 nm, FWHM 60 nm. The quantum efficiencies of the core materials at this stage range from 25-90 %

### Growth of a ZnS shell

A 20ml portion of the HF etched InP core particles was dried down in a 3-neck flask. 1.3g myristic acid and 20ml di-n-butyl sebacate ester was added and degassed for 30 minutes. The solution was heated to 200°C then 1.2g anhydrous zinc acetate was added and 2ml 1M (TMS)₂S was added dropwise (at a rate of 7.93ml/hr) after addition was complete the solution was left to stir. The solution was kept at 200°C for 1hr then cooled to room temperature. The particles were isolated by adding 40 ml of anhydrous degassed methanol and centrifuged. The supernatant liquid was disposed of and to the remaining solid 30ml of anhydrous degassed hexane was added. The solution was allowed to settle for 5hrs and then re-centrifuged. The supernatant liquid was collected and the remaining solid was discarded. PL emission peak Max. = 535 nm, FWHM = 65 nm. The quantum efficiencies of the nanoparticle core/shell materials at this stage ranged from 35-90%.

### EXAMPLE 3

### Preparation of Indium myristate 0.25M

In(Ac)3 + 1.5CH₃(CH₂)₁₂COOH → In(Ac)_{1.5}(OOC(CH₂)₁₂CH₃)_{1.5}

Myristic acid (70.798g, 0.3100 moles, 1.5eqv), Indium acetate (58.392g, 0.200 moles, 1eqv) and dibutyl sebacate (626.4ml, 568.3g, 1.864 moles) were placed into a 1L round bottomed flask and heated to 118°C under vacuum for 2 days and 1 night. A pre-trap, cooled with ice/salt/acetone, was set up, and this and the high vacuum solvent trap periodically checked and unblocked of any frozen acetic acid which had accumulated during synthesis of the Indium myristate.

### Preparation of TMSP 0.25M

A Schlenk tube and syringe were oven dried overnight. The Schlenk tube was then transferred to a vacuum line and allowed to cool. Dibutyl sebacate was degassed under vacuum and gently heated for over 1 hour before 92.74ml (0.294moles) were transferred to the Schlenk tube under nitrogen. TMSP (7.26ml, 0.025moles) were transferred under nitrogen and mixed with the dibutly sebacate.

### Preparation of InP quantum dots with Green emission and growth of a ZnS/ZnO shell

Myristic acid (140.000g, 0.444moles) and dibutyl sebacate (2800ml) were degassed under high vacuum for 1 hour at a temperature of between 60 and 90°C. The system was purged with argon and then [Et₃NH₄][Zn₁₀S₄(SPh)₁₆] cluster (13.16g) added immediately. The reaction mixture was then heated for 15 minutes until it reached a temperature of 100°C, at which stage the reaction mixture was then maintained at 100°C for 30 minutes. The cluster did not completely dissolve but instead formed a white suspension.

The first addition of indium myristate (168ml, 0.25M) was commenced at a rate of three drops per second and the temperature was kept at 100°C throughout. Upon completion of the addition of the myristate solution the reaction mixture was stirred at 100°C for 5 minutes. TMSP (168ml, 0.25M) at a rate of two drops per second was then added and again the temperature was carefully monitored. As soon as the addition was complete the temperature of the reaction mixture was increased as fast as possible to 180°C, care was taken here to ensure no overshoot. As soon as 180°C was attained another addition of indium myristate (224ml, 0.25M) was made, again at a rate of three drops per second. The reaction mixture was then held at 180°C for 30 minutes. The reaction was then allowed to cool to 160°C and annealed for three days with the temperature held between 150-160°C.

After annealing, the mixture was allowed to cool to room temperature before 500ml portions were poured into a large beaker and precipitated with acetonitrile. The flocculated solution was then transferred to centrifuge tubes and centrifuged until a pellet was formed. The clear supernatant was discarded and the orange precipitate was redissolved in the minimum amount of chloroform and left to stand in air overnight.

### Postoperative treatments

### Pre-etch in Myristic acid

The chloroform was removed on a rotary evaporator and the solid redissolved in dibutyl sebacate ester (600ml). Myristic acid (80g) was then added and the mixture heated to 140°C for 6 hrs. The mixture was allowed to cool and precipitated with acetonitrile in the same manner as described above.

### HF etching

The pellets were redissolved in cholorform (1750ml) and this solution was used to HF etch. The solution was placed in front of a 500W tungsten bulb and a solution of 2ml HF (48%) in 8ml of tetrahydrofuran added slowly with stirring. The optical emission spectrum of the solution was monitored with an optical hand probe and gradually began to red shift with increasing intensity. The HF solution was added until the point where the recorded wavelength began to blue shift, the HF/THF/CHCl₃ was then blown off with air. The resulting paste was washed in acetone, precipitated with acetonitrile and then washed in hexane and precipitated a second time in acetonitrile. The precipitate was then dissolved in the minimum amount of dibutly sebacate ester, degassed and put under argon.

### Growth of a ZnS/ZnO shell

The InP nanoparticles formed as described above were degassed for 1hour at room temperature. Carboxy-PEG-methyl ether (125.82g) was also degassed for 1 hour under high vacuum at 100°C and then allowed to cool to room temperature. Zinc acetate (34.903g, 0.1902 moles) and the degassed InP nanoparticles were added to the cooled ether and then placed under vacuum for 5 minutes and purged with argon three times. The InP nanoparticles containing solution was heated to 180°C, with degassed octanethiol (8.3111g, 0.0568moles) rapidly injected at 120°C. The reaction mixture was held at 180°C for 1 hour and then octanol (24.93g, 30.04ml, 0.1914 moles) added at a rate of 1 drop a second. The reaction mixture was then heated back up to 180°C for 30 minutes after which it was allowed to cool to room temperature before hexane (350ml) was added. The upper layer from the gel like precipitate was decanted and acetonitrile (700ml) added to the decanted solution. The mixture was then added to a separating funnel and acetone added until the precipitate began to flocculate. The solution was run off from around the flocculate and centrifuged to recover the entire product. Finally the flocculate and centrifuged precipitate was dissolved in degassed chloroform.

### EXAMPLE 4

### Preparation of InP quantum dots with Green emission

Indium myristate and TMSP were prepared according to the procedure described in Example 3.

Myristic acid (70.000g, 0.222moles) and dibutyl sebacate (1400ml) were degassed under high vacuum for 1 hour at a temperature between 60 and 90°C. The system was purged with argon and then [Et₃NH₄][Zn₁₀S₄(SPh)₁₆] cluster (6.58g) added immediately. The reaction mixture was then heated for 15 minutes until it reached a temperature of 100°C, at which stage the reaction mixture was then maintained at 100°C for 30 minutes. The cluster did not completely dissolve but instead formed a white suspension.

The first addition of indium myristate (84ml, 0.25M) was commenced at a rate of three drops per second and the temperature was kept at 100°C throughout. Upon completion of the addition of the myristate solution the reaction mixture stirred at 100°C for 5 minutes. TMSP (84ml, 0.25M) at a rate of two drops per second was then added and again the temperature was carefully monitored. As soon as the addition was complete the temperature of the reaction mixture was increased as fast as possible to 180°C, care was taken here to ensure no overshoot. As soon as 180°C was attained another addition of indium myristate (112ml, 0.25M) was made, again at a rate of three drops per second. The reaction mixture was then held at 180°C for 30 minutes. The reaction was then allowed to cool to 160°C and annealed for three days with the temperature was held between 150-160°C.

After annealing, the mixture was allowed to cool to room temperature before 500ml portions were poured into a large beaker and precipitated with acetonitrile. The flocculated solution was then transferred to centrifuge tubes and centrifuged until a pellet was formed. The clear supernatant was discarded and the orange precipitate was redissolved in the minimum amount of chloroform and left to stand in air overnight.

### Postoperative treatments

### Pre-etch in Myristic acid

The chloroform was removed on a rotary evaporator and the solid redissolved in dibutyl sebacate ester (300ml). Myristic acid (40g) was then added and the mixture heated to 140°C for 6 hrs. The mixture was allowed to cool and precipitated with acetonitrile in the same manner as described above.

### HF etching

The pellets were redissolved in cholorform (900ml) and this solution was used to HF etch. The solution was placed in front of a 500W tungsten bulb and a solution of 2ml HF (48%) in 8ml of tetrahydrofuran added slowly with stirring. The optical emission spectrum of the solution was monitored with an optical hand probe and gradually began to red shift with increasing intensity. The HF solution was added until the point where the recorded wavelength began to blue shift, the HF/THF/CHCl₃ was then blown off with air. The resulting paste was washed in acetone, precipitated with acetonitrile and then washed in hexane and precipitated a second time in acetonitrile. The precipitate was then dissolved in the minimum amount of dibutly sebacate ester, degassed, put under argon.

### EXAMPLE 5

### Preparation of InP quantum dots with Red emission

Indium myristate and TMSP were prepared according to the previous procedure.

Myristic acid (120.000g, 0.526moles) and dibutyl sebacate (2400ml) were degassed under high vacuum for 1 hour at a temperature between 60 and 90°C. The system was purged with argon and then [Et₃NH₄][Zn₁₀S₄(SPh)₁₆] cluster (11.28g) added immediately. The reaction mixture was then heated for 15 minutes until it reached a temperature of 100°C, at which stage the reaction mixture was then maintained at 100°C for 30 minutes. The cluster did not completely dissolve but instead formed a white suspension.

The first addition of indium myristate (144ml, 0.25M) was commenced at a rate of three drops per second and the temperature was kept at 100°C throughout. Upon completion of the addition of the myristate solution the reaction mixture stirred at 100°C for 5 minutes. TMSP (144ml, 0.25M) at a rate of two drops per second was then added and again the temperature was carefully monitored. As soon as the addition was complete the temperature of the reaction mixture was increased as fast as possible to 180°C, care was taken here to ensure no overshoot (it took just over 30mins to increase in temperature). As soon as 180°C was attained the second addition of indium myristate (192ml, 0.25M) was made, again at a rate of three drops per second. Again the reaction was held at 180°C for 5 minutes before the second addition of TMSP (192ml, 0.25M) at a rate of two drops per second. Immediately after the addition was completed to temperature was raised to 200°C and again care was taken not to over shoot and the final portion of Indium myristate (120ml, 0.25M) was added drop-wise. The reaction was then held at 200°C for 60 minutes after which it was cooled to 160°C. The reaction mixture was then annealed for three days with the temperature between 140 and 160°C.

After annealing, the mixture was allowed to cool to room temperature before 500ml portions were poured into a large beaker and precipitated with acetonitrile (600ml). The flocculated solution was then transferred to centrifuge tubes and centrifuged at 4000 rpm for 5 minutes. The clear supernatant was discarded and the red precipitate was redissolved in chloroform and left to stand overnight in air.

### Postoperative treatments

### Pre-etch in Myristic acid

The chloroform was removed on a rotary evaporator and the solid redissolved in dibutyl sebacate ester (600ml). Myristic acid (80g) was then added and the mixture heated to 140°C for 6 hrs. The mixture was allowed to cool and precipitated with acetonitrile in the same manner as previously discussed.

### HF etching

The pellets were redissolved in cholorform (1750ml) and this solution was used to HF etch. The solution was placed in front of a 500W tungsten bulb and a solution of 2ml HF (48%) in 8ml of tetrahydrofuran added slowly with stirring. The optical emission spectrum of the solution was monitored with an optical hand probe and gradually began to red shift with increasing intensity. The HF solution was added until the point where the recorded wavelength began to blue shift, the HF/THF/CHCl₃ was then blown off with air. The resulting paste was washed in acetone, precipitated with acetonitrile and then washed in hexane and precipitated a second time in acetonitrile. The precipitate was then dissolved in the minimum amount of dibutly sebacate ester, degassed and put under argon.

### EXAMPLE 6

### Preparation of InP quantum dots with Red emission

Myristic acid (60.000g, 0.263moles) and dibutyl sebacate (1200ml) were degassed under high vacuum for 1 hour at a temperature of between 60 and 90°C. The system was purged with argon and then [Et₃NH₄][Zn₁₀S₄(SPh)₁₆] cluster (5.64g) added immediately. The reaction mixture was then heated for 15 minutes until it reached a temperature of 100°C, at which stage the reaction mixture was then maintained at 100°C for 30 minutes. The cluster did not completely dissolve but instead formed a white suspension.

The first addition of indium myristate (72ml, 0.25M) was commenced at a rate of three drops per second and the temperature was kept at 100°C throughout. Upon completion of the addition of the myristate solution the reaction mixture was stirred at 100°C for 5 minutes. TMSP (72ml, 0.25M) at a rate of two drops per second was then added and again the temperature was carefully monitored. As soon as the addition was complete the temperature of the reaction mixture was increased as fast as possible to 180°C, care was taken here to ensure no overshoot (it took just over 30mins to increase in temperature). As soon as 180°C was attained the second addition of indium myristate (96ml, 0.25M) was made, again at a rate of three drops per second. Again the reaction was held at 180°C for 5 minutes before the second addition of TMSP (96ml, 0.25M) at a rate of two drops per second. Immediately after the addition was completed to temperature was raised to 200°C and again care was taken not to over shoot. The reaction was then held at 200°C for 60 minutes after which it was cooled to 160°C. The reaction mixture was then annealed for three days between 140 and 160°C.

### Postoperative treatments

### Pre-etch in Myristic acid

The chloroform was removed on a rotary evaporator and the solid redissolved in dibutyl sebacate ester (300ml). Myristic acid (40g) was then added and the mixture heated to 140°C for 6 hrs. The mixture was allowed to cool and precipitated with acetonitrile in the same manner as described above.

### HF etching

The pellets were redissolved in cholorform (900ml) and this solution was used to HF etch. The solution was placed in front of a 500W tungsten bulb and a solution of 2ml HF (48%) in 8ml of tetrahydrofuran added slowly with stirring. The optical emission spectrum of the solution was monitored with an optical hand probe and gradually began to red shift with increasing intensity. The HF solution was added until the point where the recorded wavelength began to blue shift, the HF/THF/CHCl₃ was then blown off with air. The resulting paste was washed in acetone, precipitated with acetonitrile and then washed in hexane and precipitated a second time in acetonitrile. The precipitate was then dissolved in the minimum amount of dibutly sebacate ester, degassed and put under argon.

### EXAMPLE 7

**Preparation of InMA₃ Precursor**

| **Material** | **Amount** | **Moles** | **MW** | **Grade** |
|---|---|---|---|---|
| Indium acetate | 100g | 0.34 | 292 | 99% |
| Myristic acid | 313g | 1.37 | 228.4 | 99-100% |
| Solvents | | | | |
| Acetone | 800mL | | | analytical |
| Dibutyl sebacate | 30mL | | 314.47 | 98% |

In a three-neck flask (1litre), In(Ac)₃ (100g) and myristic acid (313g) were heated to 140°C under nitrogen for 2 hours. The reaction mixture was cooled to 80°C and the reaction flask was attached to distillation apparatus. The reaction mixture was placed under gentle vacuum for 5 hours, after which it was left under nitrogen overnight at 60°C. (In this first step of the reaction 60mL of acetic acid was collected). In a 1 litre conical flask, analytical grade acetone (400mL) was added allowed to stir gently. The reaction mixture was slowly added to the acetone with continuous stirring. The reaction mixture was left to stir for 15mins and then left to stand. A yellow solid settled at the bottom and the excess solvent was decanted off. The yellow solid was washed with acetone 3 times until the solid was white and the discolouration in the solvent was minimal. The solid was filtered using Buchner funnel and flask apparatus and then left to dry in a desiccator under vacuum overnight. Final product: mass of InMA₃ dry powder = 226.82g.

### Preparation of InMA₃ (1Molar) Precursor solution

In a 250 mL three-neck flask, equipped with a condenser and thermometer, InMA₃ (100g) and dibutyl sebacate (30mL) was degassed thoroughly at 100°C for 1 hour and 30 minutes. The reaction temperature was maintained until the solution went colourless. The InMA₃ solution solidifies at room temperature and so, when used, should be kept at a temperature of approximately 60°C and stirred vigorously. ***Preparation of (TMSi)₃P (1Molar) Precursor solution***

| **Material** | **Amount** | **Moles** | **MW** | **Density** |
|---|---|---|---|---|
| (TMSi)₃P | 29mL | 0.10 | 250.54 | 0.863 |
| Dibutyl sebacate | 71mL | 0.10 | 314.46 | 0.936 |

In a 250mL three-neck flask, dibutyl sebacate (100 mL) was degassed for 2 hours and 30 minutes at 100°C. In an oven-dried large Schlenk tube, dibutyl sebacate (71 mL) was added followed by (TMSi)₃P (29 mL) under a strong flow of nitrogen.

**Preparation of InP quantum dots with Green emission and growth of a ZnS/ZnO shell**

| Material | Amount | Moles | MW | Grade |
|---|---|---|---|---|
| Capping agent | | | | |
| Myristic Acid | 5.125g | 0.0225 | 228.37 | 99-100% |
| Reagents | | | | |
| [Et₃NH₄]Zn₁₀S₄(SPh)₁₆ | 0.47g | 1.6x10⁻⁴ | 2937.67 | |
| Dibutyl Sebacate | 100mL | | 314.47 | 98% |
| InMA₃ (1M) | 7mL | 7x10⁻³ | 796.91 | |
| Solvents | | | | |
| Acetonitrile | 100mL | | | anhydrous |
| Chloroform | 200mL | | | |

Dibutyl sebacate (100mL) and myristic acid (5.125g) were degassed for 1 hour at 100°C under vacuum in a 250mL three-neck flask equipped with a condenser and thermometer. [Et₃NH₄]Zn₁₀S₄(SPh)₁₆ cluster (0.47g) was added at 80°C under a strong flow of nitrogen and with vigorous stirring. The reaction mixture was left to stir vigorously for 30 minutes. The reaction temperature was then increased to 100°C.

Seeding of the InP nanoparticles was initiated by slow dropwise addition of InMA₃ solution (1M,3mL), which was then left to stir vigorously for 5 minutes. After the 5 minute period, (TMSi)₃P (1M,3mL) was added slowly dropwise. The reaction temperature was then increased to 160°C. At 160°C, a second addition of InMA₃ (1M,4mL) was made slowly dropwise. The reaction mixture was left to stir for 5 minutes, before the second addition of (TMSi)₃P (1M,4mL) was made. Preferably the reaction solution should be vigorously stirred during all additions. The reaction temperature was increased to 190°C and left stirring for 1 hour. The reaction temperature was then decreased to 160°C and the reaction mixture annealed at this temperature for 3 days.

To measure the photoluminescence, slits of 5nm may be used. After the 3 day period, the reaction mixture was cooled to room temperature. The InP nanoparticles were isolated under nitrogen via the addition of anhydrous acetonitrile (100 mL). The solid was isolated using centrifugation and re-dissolved into CHCl₃ (200 mL).

### Postoperative treatments

### HF etching

The HF solution was prepared by combining 2 mL aqueous HF (58-62%wt.solution) and THF (8 mL analytical grade). HF (1.4 mL in total) was added to the InP nanoparticles dispersed in chloroform prepared as described above, in a 250 mL conical flask. The HF solution was added dropwise, 0.2 mL over a period of 7-8 hours, in air with vigorous stirring. The reaction mixture was irradiated with light passed through a cut-off filter with the cut-off wavelength depending on the size. A 500W xenon lamp was used as the light source.

The process of etching was finished after approximately 10-15 hours depending on the scale of the particular batch of nanoparticles being etched. Highly luminescent HF etched InP nanoparticles were isolated from the reaction mixture by the evaporation of CHCl₃. The HF etched InP nanoparticles were then washed with acetone (10-15 mL) followed by the addition of acetonitrile (100 mL). The solid was isolated by centrifugation and washed a second time with acetone (5 mL) before being dispersed into dibutyl sebacate (approximately 20 mL depending on scale of batch). Effectively etched InP nanoparticles exhibited strong luminescence with a PL quantum efficiency of 15-30%.

This method yielded around 2 grams of InP quantum dots with emission at 535nm (±5nm) and FWHM < 70nm.

**Growth of a ZnS/ZnO shell**

| Material | Amount | Moles | MW | Density |
|---|---|---|---|---|
| Capping agent | | | | |
| Myristic Acid | 5.2g | 0.0227 | 228.37 | 99-100% |
| Reagents | | | | |
| Dibutyl sebacate | 15mL | 0.0446 | 314.46 | 0.936 |
| Zinc acetate | 2.8g | 0.0153 | 183.48 | |
| Octanethiol | 0.82mL | 4.72x10⁻³ | 146.29 | 0.843 |
| 1-Octanol | 2.2mL | 0.0139 | 130.23 | 0.827 |
| Solvents | | | | |
| Acetonitrile | 160mL | | | |
| Toluene | 40mL | | | |

Dibutyl sebacate (15mL) and myristic acid (5.2g) were degassed at 100°C for 1 hour and 30 minutes in a 250mL three-neck flask attached to a condenser with a side arm and a thermometer. InP nanoparticles (2.32g) prepared as described above were degassed in a separate flask for 1 hour. The reaction mixture of dibutyl sebacate (15mL) and myristic acid (5.2g) was cooled down to approximately 60°C and the InP nanoparticles added. The reaction mixture was degassed for a further 45 minutes.

Zinc acetate (2.8g) was added in one portion through a side arm under a strong flow of nitrogen with vigorous stirring. The reaction mixture was degassed for 15 minutes and flushed with N₂ several times in-between degassing. The reaction temperature was increased to 120°C.

Octanethiol (0.82mL) was added at 120°C quickly and the temperature ramped up to 220°C. To form the ZnS shell, the temperature was held at 220°C for 1 hour and 30 minutes. The reaction solution was then cooled down to 180°C.

1-Octanol (2.2mL) was added slowly dropwise at 180°C. After addition was complete, the solution was left stirring for 30 minutes at 190°C in order to form the ZnO shell.

The reaction mixture was cooled to room temperature and left stirring overnight. InP/ZnS/ZnO core-shell particles were isolated under N₂ with anhydrous acetonitrile (80mL) and collected by centrifugation. The particles were dispersed into toluene (20mL) and re-precipitated with acetonitrile followed by centrifugation. The particles were then re-dispersed into toluene (20mL). The final solution was centrifuged to remove any insoluble material. Final product: mass = 1.62g, PLₘₐₓ= 521nm, FWHM = 61nm, PLQY = 64%.

### EXAMPLE 8

**Preparation of InP quantum dots with Red emission**

| Material | Amount | Moles | MW | Grade |
|---|---|---|---|---|
| Capping agent | | | | |
| Myristic Acid | 5.125g | 0.0225 | 228.37 | 99-100% |
| Reagents | | | | |
| [Et₃NH₄]Zn₁₀S₄(SPh)₁₆ | 0.47g | 1.6x10⁻⁴ | 2937.67 | |
| Dibutyl Sebacate | 100mL | | 314.47 | 98% |
| InMA₃ (1M) | 10mL | 0.01 | 796.91 | |
| (TMSi)₃P (1M) | 9.25mL | 9.25x10⁻³ | 250.54 | |
| Solvents | | | | |
| Acetonitrile | 100mL | | | anhydrous |
| Chloroform | 200mL | | | |

Dibutyl sebacate (100mL) and myristic acid (5.125g) were degassed for 1 hour at 100°C under vacuum in a 250mL three-neck flask equipped with a condenser and thermometer. [Et₃NH₄]Zn₁₀S₄(SPh)₁₆ cluster (0.47g) was added at 80°C under a strong flow of nitrogen with vigorous stirring. The reaction mixture was left to stir vigorously for 30 minutes. The reaction temperature was increased to 100°C. Seeding of the InP nanoparticles was initiated by slow dropwise addition of InMA₃ solution (1M,3mL) which was then left to stir vigorously for 5 minutes. After the 5 minute period, (TMSi)₃P (1M,3mL) was added slowly dropwise. The reaction temperature was increased to 160°C. At 160°C, a second addition of InMA₃ (1M,4mL) was made slowly dropwise. The reaction mixture was left to stir for 5 minutes, before the second addition of (TMSi)₃P (1M,4mL) was made. The reaction temperature was increased to 180°C and a third addition of InMA₃ solution (1M,3mL) was made followed by (TMSi)₃P (1M,2.25mL). Preferably the reaction solution should be vigorously stirred during all additions. The reaction temperature was increased to 200°C and left stirring for 1 hour. The reaction temperature was then decreased to 170°C and the reaction mixture annealed at this temperature for 3 days.

To measure the photoluminescence, slits of 5nm may be used. After the 3 day period, the reaction mixture was cooled to room temperature. InP cores were isolated under nitrogen via the addition of anhydrous acetonitrile (100 mL). The solid was isolated using centrifugation and re-dissolved into CHCl₃ (200 mL).

### Postoperative treatments

### HF etching

The HF solution was prepared by combining 4 mL aqueous HF (58-62%wt.solution) and THF (16 mL analytical grade). HF (5 mL in total) was added to the InP nanoparticles dispersed in chloroform, in a 250 mL conical flask. The HF solution was added dropwise, 0.2 mL over a period of 5-8 hours, in air with vigorous stirring. The reaction mixture was irradiated with light passed through a cut-off filter with the cut-off wavelength depending on the size. A 500W xenon lamp is used as the light source.

The process of etching is finished after approximately 10-15 hours depending on scale of the particular batch of nanoparticles being etched. Highly luminescent HF etched InP nanoparticles were isolated from the reaction mixture by the evaporation of CHCl₃. The HF etched InP nanoparticles are then washed with acetone (10-15 mL) followed by the addition of acetonitrile (100 mL). The solid was isolated by centrifugation and washed a second time with acetone (5 mL) before being dispersed into dibutyl sebacate (approximately 20 mL depending on scale of batch). Effectively etched InP nanoparticles exhibit strong luminescence with a PL quantum efficiency of 15-30%.

This method yielded around 2 grams of InP quantum dots with emission at 610nm (±5nm) and FWHM < 90nm.

**Growth of a ZnS/ZnO shell**

| **Material** | **Amount** | **Moles** | **MW** | **Density** |
|---|---|---|---|---|
| Capping agent | | | | |
| Myristic Acid | 6.71g | 0.0294 | 228.37 | 99-100% |
| Reagents | | | | |
| Dibutyl sebacate | 15mL | | 314.46 | 0.936 |
| Zinc acetate | 3.61g | 0.0197 | 183.48 | |
| Octanethiol | 1.1mL | 6.34x10⁻³ | 146.29 | 0.843 |
| 1-Octanol | 2.84mL | 0.0180 | 130.23 | 0.827 |
| Solvents | | | | |
| Acetonitrile | 160mL | | | |
| Toluene | 80mL | | | |

Dibutyl sebacate (15mL) and myristic acid (6.71g) were degassed at 100°C for 1 hour and 30 minutes in a 250mL three-neck flask attached to a condenser with a side arm and a thermometer. InP nanoparticles (2.58g) prepared as described above were degassed in a separate flask for 1 hour. The reaction mixture of dibutyl sebacate (15mL) and myristic acid (6.71g) was cooled down to approximately 60°C and the InP nanoparticles added. The reaction mixture was degassed for a further 45minutes.

Zinc acetate (3.61g) was added in one portion through a side arm under a strong flow of nitrogen with vigorous stirring. The reaction mixture was degassed for 15 minutes and flushed with N₂ several times in-between degassing. The reaction temperature is increased to 120°C.

Octanethiol (1.1mL) was added at 120°C quickly and the temperature ramped up to 220°C. To form the ZnS shell, the temperature was held at 220°C for 1 hour and 30 minutes. The reaction solution was then cooled down to 180°C.

1-Octanol (2.84mL) as added slowly dropwise at 180°C. After addition was complete, the solution is left stirring for 30 minutes at 190°C in order to form the ZnO shell.

The reaction mixture was cooled to room temperature and left stirring overnight. InP/ZnS/ZnO core-shell particles were isolated under N₂ with anhydrous acetonitrile (80mL) and collected by centrifugation. The particles were dispersed into toluene (30mL) and are re-precipitated with acetonitrile followed by centrifugation. The particles were then re-dispersed into toluene (50mL). The final solution is centrifuged to remove any insoluble material. Final product: mass = 3.2g, PLₘₐₓ= 605nm, FWHM = 93nm, PLQY = 61%.

### REFERENCES

1. Murray, C. B.; Norris, D. J.; Bawendi, M. G. J. Am. Chem. Soc. 1993, 115, 8706.
2. LØver, T.; Bowmaker, G. A.; Seakins, J. M.; Cooney, R. P.; Henderson, W. J. Mater. Chem., 1997, 7(4), 647.
3. Cumberland, S. L.; Hanif, K. M.; Javier, A.; Khitov, K. A.; Strouse, G. F.; Woessner, S. M.; Yun, C. S. Chem. Mater. 2002, 14, 1576.

## Claims

1. A nanoparticle comprised of a molecular cluster compound incorporating ions from groups 12 and 16 of the periodic table, and a core semiconductor material provided on said molecular cluster compound, wherein the core semiconductor material incorporates ions from groups 13 and 15 of the periodic table.

2. A nanoparticle according to claim 1, wherein the molecular cluster compound and the core semiconductor material have compatible crystal phases which permit growth of said core semiconductor material on said molecular cluster compound.

3. A nanoparticle according to claim 1, wherein the molecular cluster compound and the core semiconductor material have the same crystal phase.

4. A nanoparticle according to any preceding claim, wherein the molecular cluster compound incorporates zinc ions.

5. A nanoparticle according to any preceding claim, wherein the molecular cluster compound incorporates group 16 ions selected from the group consisting of sulfide ions, selenium ions and telluride ions.

6. A nanoparticle according to any preceding claim, wherein the core semiconductor material incorporates group 13 ions selected from the group consisting of aluminium ions, gallium ions and indium ions, and/or group 15 ions selected from the group consisting of nitride ions, arsenide ions and antimonide ions.

7. A nanoparticle according to any preceding claim, wherein the nanoparticle exhibits a quantum efficiency in the range around 20 to 60 %.

8. A nanoparticle according to any preceding claim, wherein the nanoparticle comprises a first layer comprising a first semiconductor material provided on said nanoparticle core.

9. A nanoparticle according to claim 8, wherein said first semiconductor material incorporates ions from group 12 of the periodic table, and/or ions from group 16 of the periodic table.

10. A nanoparticle according to any preceding claim, wherein the nanoparticle comprises a second layer comprising a second semiconductor material provided on said first layer.

11. A method for producing a nanoparticle comprising a molecular cluster compound incorporating ions from groups 12 and 16 of the periodic table, and a core semiconductor material provided on said molecular cluster compound, the core semiconductor material incorporating ions from groups 13 and 15 of the periodic table, the method comprising effecting conversion of a nanoparticle core precursor composition comprising first and second core precursor species containing the ions from groups 13 and 15 of the periodic table respectively to the material of the nanoparticle core in the presence of the molecular cluster compound incorporating ions from groups 12 and 16 of the periodic table under conditions permitting seeding and growth of the nanoparticle core material.

12. A method according to claim 11, wherein the molecular cluster compound incorporates zinc ions, and/or incorporates group 16 ions selected from the group consisting of sulfide ions, selenium ions and telluride ions.

13. A method according to claim 11 or 12, wherein the core semiconductor material incorporates group 13 ions selected from the group consisting of aluminium ions, gallium ions and indium ions and/or group 15 ions selected from the group consisting of nitride ions, arsenide ions and antimonide ions.

14. A method according to any one of claims 11 to 13, wherein said first and second core precursor species are separate entities contained in said core precursor composition, or are combined in a single entity contained in said core precursor composition.

15. A method according to any one of claims 11 to 14, wherein the method further comprises forming a first layer comprised of a first semiconductor material on the nanoparticle core material.
